# EUROPÄISCHE PATENTANMELDUNG

(11) **EP 1 256 983 A2**
(43) Veröffentlichungstag der Anmeldung: **13.11.2002**
(21) Anmeldenummer: 02100445.2
(22) Anmeldetag: 06.05.2002
(51) Int. Cl.: H01L 23/538, H01L 23/498, H01L 21/78

(54) **Flexible integrierte monolithische Schaltung**

(30) Priorität: 08.05.2001 DE 10122324
(71) Anmelder: Philips Corporate Intellectual Property GmbH, 20099 Hamburg (DE); Koninklijke Philips Electronics N.V., 5621 BA Eindhoven (NL)
(72) Erfinder: Fock, Johann-Heinrich, Dr. c/o Philips Corporate, 52066 Aachen (DE); Schnitt, Wolfgang c/o Philips Corporate, 52066 Aachen (DE); Pohlmann, Hauke, Dr. c/o Philips Corporate, 52066 Aachen (DE); Gakis, Andreas c/o Philips Corporate, 52066, Aachen (DE); Burnus, Michael, Dr. c/o Philips Corporate, 52066 Aachen (DE); Schäfer, Martin, Dr. c/o Philips Corporate, 52066 Aachen (DE); Maas, Henricus Godefridus Rafaelc/o Philips Corp., 52066 Aachen (DE); Michielsen, Theodorus Martinus c/o Philips Corp., 52066 Aachen (DE); Dekker, Ronald c/o Philips Corporate, 52066 Aachen (DE)
(74) Vertreter: Volmer, Georg, Dipl.-Ing.

(57) **Zusammenfassung**

Eine flexible, monolithische integrierte Schaltung, die im wesentlichen aus flexiblen Schaltungselementen, Verbindungselementen zwischen den flexiblen Schaltungselementen und einer flexiblen Beschichtung, die mindestens eine Schicht aus einem Beschichtungsmaterial, das ein Polymer enthält, besteht, eignet sich als kleine und handliche integrierte Schaltung für Elektronik auf flexiblen Datenträgern zur logistischen Verfolgung von Objekten und Personen

Die Erfindung betrifft auch ein Verfahren zur Herstellung einer flexiblen integrierten monolithischen Schaltung, bei dem integrierte monolithische Schaltungselemente und Verbindungselemente in und auf einem Halbleitersubstrat gebildet werden, die dem Halbleitersubstrat abgewandte Hauptoberfläche der integrierten Schaltungselemente mit einem Polymerharz beschichtet wird und das Halbleitersubstrat entfernt wird. Das Verfahren basiert auf den gängigen Verfahrensschritten der Halbleitertechnologie und führt in wenigen Verfahrensschritten zu einer flexiblen, integrierten monolithischen Schaltung

## Beschreibung

Die Erfindung betrifft eine flexible integrierte monolithische Schaltung, die flexible Schaltungselemente umfaßt.

Konventionelle monolithische integrierte Schaltungen enthalten die unterschiedlichen Schaltungselemente, wie Dioden, Transistoren, Widerstände, Kondensatoren und Spulen in oder auf einem gemeinsamen einkristallinen Halbleiter-Plättchen eingearbeitet. Der vielfältige, komplexe Aufbau der integrierten Schaltung aus halbleitenden Zonen, isolierenden Sperrgebieten und metallisch leitenden Verbindungen ist hauchdünn, er reicht oft nur einige Mikrometer in die Tiefe und die elektrischen Ladungsträger bewegen sich in dünnen Schichten und Kanälen praktisch an der Chipoberfläche.

Experimente haben gezeigt, dass dünne Schichten aus Halbleitermaterial mit einer Schichtdicke von weniger als 50µm an sich flexibel sind und dass integrierte Schaltungen mit dieser Schichtdicke auch nach wiederholter Biegsbeanspruchung funktionsfähig bleiben. Erst die im Vergleich zu der Tiefe der Schaltungselemente große Dicke der Halbleiterplättchen konventioneller Bauart macht die Chips starr.

Wenn es gelingt, die Oberflächenschicht mit den Funktionselemente und ihren Verbindungen von dem starren Untergrund zu lösen, ist es möglich, flexible integrierte Schaltungen herzustellen.

Bekannte flexible integrierte Schaltungen dieser Art sind aufgrund einer steigenden Nachfrage nach kleinen und handlichen integrierten Schaltungen für Elektronik auf flexiblen Datenträgern zur logistischen Verfolgung von Objekten und Personen ins Zentrum vielseitiger technologischer Anstrengungen gerückt.

Besonders bei Chipkarten als Speicherkarten oder Smart Cards gehen die Entwicklungstrends dahin, eine Multifunktionskarte mit kontaktbehafteter oder kontaktloser Datenübertragung zu entwickeln, so dass die Anwendung der Chipkarte auf unterschiedlichste Gebiete, wie Zahlungsverkehr, Gesundheitswesen, Telekommunikation und Sicherheitsbereich erweitert werden kann. Dazu werden sie mit immer größeren elektronischen Halbleiterschaltungen bestückt, um mehr elektronische Funktionen auf der Karte unterzubringen. Wenn diese Halbleiterschaltungen in konventioneller Halbleitertechnik auf einem starren Chip ausgeführt sind, neigen sie dazu, zu reißen oder zu brechen, wenn der Benutzer sie verbiegt. Für Chipkarten besteht also ein Bedarf an integrierten Schaltungen mit höherem Integrationsgrad, die starken mechanischen Beanspruchungen gewachsen sind

Bekannt ist aus US 6,027,958 eine flexible integrierte Schaltung für Smart Cards, die ein Siliciumhalbleitermaterial auf einer Siliciumdioxidschicht, eine integrierte Schaltung, die mit dem Siliciumhalbleitermaterial hergestellt ist, eine Einkapselungsschicht aus Siliciumdioxid oder Siliciumnitrid zur Versiegelung der integrierten Schaltung und eine flexible Stützschicht, die mit der integrierten Schaltung verbunden ist, umfasst.

Eine flexible integrierte Schaltung nach der US 6,027958 ist aber mit verschiedenen Nachteilen bei der Herstellung und beim Betreiben behaftet. So umfasst etwa der Herstellungsprozess eine Vielzahl von Prozessschritten, die die Herstellungskosten und die Ausschußquote in die Höhe treiben. Bei flexiblen integrierten Schaltungen muß auch der Qualität der Schichten und insbesondere deren Haftung und damit zusammenhängenden Delaminationserscheinungen spezielle Beachtung geschenkt werden. Einkapselungsschichten aus SiO₂ oder Si₃N₄ sind spröde, brechen leicht, neigen zur Rißbildung und haften schlecht.

Es ist daher eine Aufgabe der vorliegenden Erfindung eine flexible integrierte Schaltung zur Verfügung zu stellen, die verbesserte Verbundeigenschaften hat und einfach und kostengünstig in nahezu jeder Größe realisiert werden kann.

Erfindungsgemäß wird die Aufgabe gelöst durch eine flexible integrierte monolithische Schaltung, die im wesentlichen aus flexiblen Schaltungselementen, Verbindungselementen zwischen den flexiblen Schaltungselementen und einer flexiblen Beschichtung, die mindestens eine Schicht aus einem Beschichtungsmaterial, das ein Polymer enthält, besteht.

Die flexible Beschichtung aus einem Beschichtungsmaterial, das ein Polymeres enthält, erfüllt gleichzeitig drei Funktionen: Sie wirkt als Passivierungsschicht, als Planarisierungsschicht und als mechanischer Träger für die integrierten Schaltungselemente und ihre Verbindungselemente. Die Polymerenschicht dient der Passivierung und Planarisierung der Schaltungselemente. Gleichzeitig ergibt die Polymerenschicht für das Endprodukt eine ausreichende mechanische Stabilität, um als alleiniger Träger für die integrierte monolithische Schaltung zu dienen.

Im Rahmen der vorliegenden Erfindung ist es bevorzugt, dass das Polymer ausgewählt ist aus der Gruppe der Polyimid-, Polycarbonat-, Fluorcarbon-, Polysulfon-, Epoxid-, Phenol-, Melamin, Polyester- und Siliconharze bzw. ihrer Copolymeren.

Besonders bevorzugt ist es, dass das Polymer aus der Gruppe der Polyimidharze ausgewählt ist. Dadurch ist die erfindungsgemäße flexible integrierte monolithische Schaltung sehr wenig anfällig für eine Delamination der Schichten.

Nach einer Ausführungsform der Erfindung enthält das Beschichtungsmaterial ein Verstärkungsmaterial zur mechanischen Verstärkung der Beschichtung

Nach einer anderen Ausführungsform der Erfindung enthält das Beschichtungsmaterial einen thermisch leitenden Füllstoff. Die Füllstoffe zur Verbesserung der thermischen Leitfähigkeit gleichen die geringe Wärmeleitfähigkeit von Polymerwerkstoffen aus.

Zur optischen Abschirmung der integrierten Schaltung kann das Beschichtungsmaterial der flexiblen, integrierten monolithischen Schaltung ein Pigment enthalten.

Nach einer weiteren Ausführungsform der Erfindung enthält das Beschichtungsmaterial einen elektrisch leitenden Füllstoff. Eine mit elektrisch leitendem Füllstoff gefüllte Beschichtung erlaubt es, Kontakte durch Druckkontaktierung ohne das aufwendige Ätzen von Kontaktlöchern herzustellen. Zudem kann der elektrisch leitende Füllstoff auch eine elektromagnetische Abschirmung der Schaltungselemente bilden.

Ebenfalls zur elektromagnetischen Abschirmung der integrierten Schaltung kann die Beschichtung auch eine Feldplatte enthalten.

Nach einer bevorzugten Ausführungsform der Erfindung umfasst die Beschichtung eine erste Schicht auf einer ersten Oberfläche und eine zweite Schicht auf einer zweiten Oberflächen der flexiblen integrierten monolithischen Schaltung. Dadurch sind die Schaltungselemente in eine Polymerenfolie eingebettet. Die zweiseitige Beschichtung vermindert die Oberflächenspannungen und bietet mechanischen Schutz für beide Hauptoberflächen der flexiblen integrierten monolithischen Schaltung.

Die Erfindung betrifft auch ein Verfahren zur Herstellung einer flexiblen integrierten monolithischen Schaltung, bei dem integrierte monolithische Schaltungselemente und Verbindungselemente in und auf einem Halbleitersubstrat gebildet werden, die dem Halbleitersubstrat abgewandte Hauptoberfläche der integrierten Schaltungselemente mit einem Polymerharz beschichtet wird und das Halbleitersubstrat entfernt wird

Das Verfahren basiert auf den gängigen Verfahrensschritten der Halbleitertechnologie und führt in wenigen Verfahrensschritten zu einer flexiblen, integrierten monolithischen Schaltung.

Besonders bevorzugt ist ein Verfahren, bei dem die Beschichtung, die ein Polymeres umfasst, durch ein Schleuderbeschichtungsverfahren aufgebracht wird. Eine Schleuderbeschichtung wirkt hervorragend einebnend. Durch das Aufbringen der Beschichtung durch ein Schleuderbeschichtungsverfahren werden die Oberflächenstufen der integrierten Schaltungselemente eingeebnet und man erhält eine Schaltung mit einer planen Oberfläche.

Nachfolgend wird die Erfindung anhand von sechs Figuren weiter erläutert.

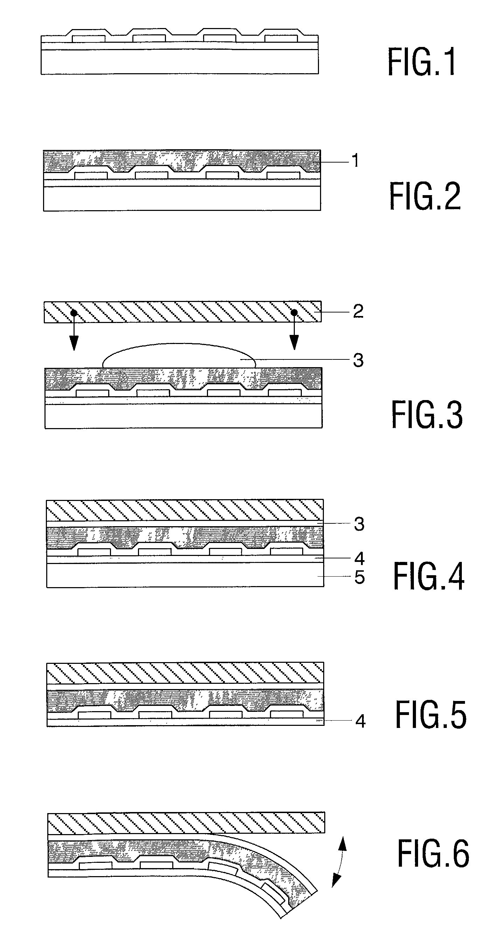

Fig 1 bis 6 zeigen schematisch die Zwischenprodukte des erfindungsgemäßen Herstellungsverfahrens in einer Querschnittsansicht.

Die erfindungsgemäße flexible, monolithische integrierte Schaltung besteht im wesentlichen aus flexiblen Schaltungselementen, Verbindungselementen zwischen den flexiblen Schaltungselementen und einer flexiblen Beschichtung, wobei die flexible Beschichtung mindestens eine Schicht aus einem Beschichtungsmaterial, das ein Polymer enthält, umfaßt. Eine solche integrierte Schaltungen kann beispielsweise als Speicherschaltung, als digitale Schaltung oder als analoge Schaltung ausgebildet sein.

Die Schaltungselemente 2 der flexiblen integrierten monolithischen Schaltung können alle geeigneten aktiven und passiven Bauelemente umfassen, z.B. Dioden, Schottky-Dioden, CMOS-Transistoren, bipolare Transistoren, Dünnschichttransistoren, Kondensatoren, Widerstände, Spulen, Mikro- und Nano-Bauteile wie IR- und UV-Sensoren, Gassensoren, optoelektronische Bauteile, sowie die zugehörigen Verbindungselemente.

Die Verbindungselemente stellen den elektrischen Kontakt zwischen den dotierten Gebieten der integrierten Schaltungselemente her und verbinden die einzelnen Komponenten einer integrierten monolithischen Schaltung. Sie führen die Anschlüsse weiter bis zum Rand der integrierten monolithischen Schaltung, wo sie zu Kontaktflecken (Bondpads) aufgeweitet werden. Üblicherweise sind die Verbindungselemente auf einer oder beiden Hauptoberflächen der flexiblen integrierten monolithischen Schaltung angeordnet.

Die flexible integrierte monolithische Schaltung umfaßt weiterhin eine flexible Beschichtung, wobei die flexible Beschichtung mindestens eine Schicht aus einem Beschichtungsmaterial, das ein Polymer enthält, umfaßt. Die flexible Beschichtung kann weiterhin Schichten aus anderen Materialien enthalten, z.B. aus einem dielektrische Material, das die integrierte Schaltung elektrisch isoliert oder sie zusätzlich vor Umwelteinflüssen schützt. Die flexible Beschichtung kann auch zwei Schichten umfassen, die jeweils auf einer der beiden Hauptoberflächen der integrierten Schaltungselemente angeordnet sind und gemeinsam die integrierte Schaltung einsiegeln: Die zweite Schicht auf der zweiten Seite vermindert die Oberflächenspannungen.

Die Dicke der Polymerschichten liegt typischerweise bei 1 bis 50 µm, bevorzugt bei 2 bis 5 µm.

Als Polymere können beispielsweise Epoxid-, Phenol-, Melamin, Polyester- und Siliconharze bzw. ihre Copolymere allein oder in Mischung mit anderen Polymeren verwendet werden, die durch Fasern, Pigmente, Füllstoffe, Glas oder Metall verstärkt werden können. Hochwertige Erzeugnisse, die auch bei höheren Arbeitstemperaturen noch stabil sind, basieren auf Polyimidharzen, Polycarbonatharzen, Fluorcarbonharzen (Teflon) oder Polysulfonharzen.

Als Beschichtungsmaterial besonders bevorzugt sind die Polymerharze, ausgewählt aus der Gruppe der Polyimide und Benzocydobutadien.

Polyimide sind Polymerharze, die aromatische Gruppen und die Säureimid-Gruppierung enthalten. Beispiele für Polyimid-Polymere sind die Polyimide, die Polyisoimide, Maleinimide, Bismaeinimide, Polyamideimide, Polymid-Imide, Polyether-Imide und Polyimid-Isoindoloquinazolin(e)dionimid. Bevorzugt als Polyimid ist Kapton®, das aus 4,4'-Oxydianilin und Pyromellithsäuredianhydrd polykondensiert wird.

Die Polyimide wirken als Spannungspuffer. Sie haben eine ausgezeichnete Kratzfestigkeit, die sie als mechanische Schutzschicht geeignet machen.

Als flexibles Beschichtungsmaterial kann auch bevorzugt Benzocyclobutadien verwendet werden. Es zeichnet sich durch eine niedrigere Wasseraufnahme und niedrigere Prozesstemperaturen aus

Nach einer weiteren bevorzugten Ausführungsform der Erfindung ist das Beschichtungsmaterial ein verstärktes Polymer. Die Verstärkung kann eine mechanische Verstärkung, eine Verbesserung der thermischen oder der elektrischen Leitfähigkeit der Polymerenschicht oder eine optische Abschirmung der Schaltungselemente bewirken.

Als mechanische Verstärkungsmaterial eignen sich z.B. organische polymere Fasern wie Aramidfasern, Kohlenstofffasern oder Glasfasern.

Mit dem Zuschlag von thermisch leitenden Füllstoffen kann man die Wärmeleitfähigkeit der Harzmatrix verbessern. Polymere Schichten wirken als mehr oder wenigsr große Wärmewiderstände und müssen bei der Aufstellung der Wärmebilanz einer integrierten monolithischen Schaltung berücksichtigt werden. Bevorzugt eingssetzt werden Aluminiumoxid, Bornitrid und Kupferpartikel mit oxidierter Oberfläche.

Füllstoffe zur Verbesserung der elektrischen Leitfähigkeit können die geringe elektrische Leitfähigkeit von Polymerwerkstoffen ausgleichen. Als isotrop leitender Füllstoff ist Silber in Plättchen- bzw. Flockenform (flakes) der geeignetste Füllstoff. Weitere bevorzugte elektrisch leitende Füllstoffe umfassen Graphit und Metallpartikel, die Kupfer, Nickel, Gold oder Aluminium enthalten..

Als Pigmente zur optischen Abschirmung können SnO₂, ITO, TiO₂ und ZnO verwendet werden

Die erfindungsgemäße flexible integrierte monolithische Schaltung wird durch ein Verfahren hergestellt, bei dem integrierte monolithische Schaltungselemente und Vebindungselementen in und auf einem Halbleitersubstrat gebildet werden, die dem Halbleitersubstrat abgewandte erste Oberfläche der integrierten Schaltungselemente und der Verbindungselemente mit einer Beschichtung, die mindestens eine Schicht aus einem Beschichtungsmaterial, das ein Polymer enthält, versehen wird und das Halbleitersubstrat entfernt wird.

Ein Verfahren zur Bildung von einer flexiblen integrierten monolithischen Schaltung nach einer ersten Ausführungsform wird nachfolgend an Hand der Figuren 1 bis 6, die die Herstellungsstufen im Querschnitt darstellens näher beschrieben.

Die integrierte monolithische Schaltung wird zunächst als ein Bauteil, bei dem alle integrierten Schaltungselemente, z.B. Dioden, Transistoren, Widerstände, einschließlich der Verbindungen zwischen den integrierten Schaltungselementen in oder auf einem gemeinsamen ersten temporären Substrat in der Art und Weise, wie sie dem Fachmann bekannt sind, angeordnet sind und zusammen das Bauteil bilden, aufgebaut.

Fig 1 zeigt ein planares erstes temporäres Halbleitersubstrat 1. Das Halbleitersubstrat 1 kann aus einer Vielzahl von möglichen Substraten ausgewählt sein, z. B einkristallinem. Silicium in Halbleiterqualität, polykristallinem Silicium in Halbleiterqualität, amorphem Silicium in Halbleiterqualität. Silicium auf Glas, Silicium auf Saphir oder auf Quarz. Das in Fig 1 dargestellte Halbleitersubstrat ist ein SOI-Substrat mit einer monokristallinen Siliciumscheibe 11 und einer Oxidschicht 12.

Aktive und gegebenenfalls auch passive Schaltungselemente 2 werden in oder auf einer der Hauptflädren des Substrates in konventioneller Halbleitertechnologie z. B. in Planartechnologie oder SOI-Technologie gebildet.

Zur Herstellung der integrierten Schaltungselemente werden Prozesse an oder in der Nähe der Oberfläche eines Einkristalls von definiertem Leitungstyp und exaktem Leitfähigkeitsbereich durchgeführt. Die Einbringung der Schaltungselemente erfolgt z.B. in Planar oder SOI-Technologie selektiv mit Hilfe mehrere Oxidationsstufen, Photolithographieschritten, selektiver Ätzungen und zwischengeschalteter Dotierschritte, wie Diffusion oder Ionenimplantation.

Für die Verbindungselemente aus Metallen, Metallsiliciden oder hochdotiertem Polysilicium, die die Schaltungselemente einer integrierten Schaltung miteinander und mit den Kantaktflächen am Rande der Schaltung verbindet, überzieht man erst die ganze Waferfläche mit einem Metall, Metallsilicid oder hochdotiertem Polysilicium und entfernt danach zur Strukturierung die überflüssigen Bereiche der Schicht durch nasschemisches oder trockenes Ätzen

Die auf dem Halbleitersubstrat aufgebauten integrierten Schaltungselementen einschließlich Verbindungselementen werden als nächstes auf der dem Halbleitersubstrat abgewandten Oberfläche mit der flexiblen Beschichtung 3 beschichtet.

Dazu wird eine dünne Schicht aus einem Beschichtungsmaterial, das ein Polymeres enthält, auf die gesamte Oberfläche oder Teile derselben aufgetragen. Bevorzugt wird die Schicht durch Aufschleudern (Spin-coating), Aufsprühen oder durch Filmbildung aufgebracht und anschließend thermisch ausgehärtet.

Als Ausgangssubstanz für eine Schicht aus einem Polyimidharz dient die in einem Lösungsmittel gelöste chemische Vorstufe des Polyimids. Nach dem Aufschleudern des Lacks auf die Wafer wird das Lösungsmittel bei 100°c abgedampft. Die Polymerisation erfolgt bei einer Temperatur von 300 bis 400°C.

Nach einer Ausführungsform der Erfindung enthält die Polymerenschicht eine Feldplatte (Floating Junction). Um eine Feldplatte zu erzeugen, kann eine erste dünne Schicht des Polymeren aufgebracht werden, danach eine sehr dünne Schicht eines leitfähigen Materials und dann eine weitere Schicht aus einem Polymeren.

Der Wafer mit dem ersten temporären Halbleitersubstrat 1 und den darauf angeordneten Schaltungselementen 2, die mit einer flexiblen Beschichtung 3 beschichtet sind, wird als nächstes mit der beschichteten ersten Hauptoberfläche mittels einer Haftschicht (release layer) 4 auf einem zweiten temporären Trägersubstrat (Handhabungswafer) 5 befestigt, wie es schematisch in Fig3 und 4 gezeigt ist.

Die Haftschicht ist bevorzugt eine Schicht, die leicht durch einen thermischen Prozess oder durch ein Lösungsmittel oder durch ein anderes Verfahren, das wenig thermisch, mechanisch oder chemisch belastend auf die Schaltungselemente wirkt, wieder entfernt werden kann. Der thermische Prozess soll bevorzugt unter 300 °C, insbesondere unter 150 °C, ablaufen. Eine geeignete Haftschicht ist eine Photoresistschicht aus einem Photoresistmaterial, das in Aceton löslich ist. Die Haftschicht kann durch Schleuderbeschichtung aufgebracht werden. Alternativ kann die Haftschicht auch aus Wachs sein

Der zweite temporäre Träger (Handhabungswafer) kann aus jedem geeigneten Material bestehen, z.B. aus einem Halbleitermaterial, aus einem keramischen Material wie Aluminiumoxid, Glas oder Quarz oder aus einem Metall, wie Aluminium.

Das erste temporäre Halbleitersubstrat wird nun von der anderen Hauptoberfläche her abgetragen, bis die Rückseite der integrierten Schaltungselemente frei liegt, siehe Fig 5.

Zur Abtragung des ersten Halbleitersubstrates bieten sich die Läpptechnik, das nasschemische Ätzen und das Schleifen der Scheibenrückseite an.

Beim Läppen wird die Schaltungsseite der Scheiben mit Wachs auf den Rotor eines Läppgsrätes geklebt, so dass ihre Rückseite auf der Läppscheibe gleitet. Als Läppmittel dient Siliciumkarbid- oder Aluminiumoxidpulver, das mit Wachs vermischt wird. Damit läßt sich die Scheibendicke auf 250 µm reduzieren.

Alternativ ist ein Abtragen des ersten Substrates durch nasschemische Ätzlösungen möglich, wobei Lack oder Wachs die strukturierte Oberfläche maskiert. Verdünnte Mischungen aus Fluss- und Salpetersäure ermöglichen Ätzraten von 1-2 µm/min. Dieser Ätzprozess kann auch im Anschluss an den Läppprozess durchgeführt werden.

Ein geeignetes Verfahren ist das Schleifen zur Abtragung des ersten Substrates. Rotierende, diamantbestückte Schleifscheiben tragen das störende Material im Grobschliff mit hoher Rate von der Rückseite des Wafers ab. Im anschließenden Feinschliff entsteht eine Oberfläche mit einer Rauhigkeit von weniger als 100 nmbei einer Dickentoleranz der Scheibe von +/- 3µm.

Altemativ kann das erste Substrat auch abgespalten werden, wenn die integrierten Schaltungselemente auf einer leicht spaltbaren Substratschicht, z.B. einer porösen Siliciumdioxidschicht, aufgebracht sind.

Zu diesem Zeitpunkt der Fertigungssequenz kann fakultativ auf die jetzt freiliegende Rückseite der integrierten Schaltungselemente eine zusätzliche Metallisierungsebene mit Bondpads aufgebracht werden. Ebenso kann auf die Rückseite eine weitere Polymerenbeschichtung aufgebracht werden. In einer anderen Ausführungsform kann eine Schutzfolie, die auch der mechanischen Stabilität dienen kann, mit geeigneten Mitteln aufgeklebt oder sonstwie aufgebracht werden.

Danach kann die Verbindung zwischen zweiten temporärem Träger (Handhabungswafer) und der flexiblen Beschichtung aufgelöst werden. Als Verfahren eignen sich z B. ein Abschälen der flexiblen integrierten Schaltung durch Befestigen eines Klebebandes und Abziehen der "Folie' oder eine chemische, thermische oder mechanische Behandlung der Haftschicht.

Nach der Trennung gemäß Fig 6 von dem temporären Handhabungswafer und gegebenenfalls der Haftschicht bilden die flexible Beschichtung und die Schaltungselemente einschließlich Verbindungselemente die flexible integrierte Schaltung.

Danach steht ein Halbleiterfilm mit integrierten Schaltungselementen mit den zugehörigen Verbindungselementen, vollständig kontaktiert, frei von den Resten des ersten Halbleitersubstrats und mit definierter Rückseite für die weitere Bearbeitung zur Verfügung

Die ganze Struktur ist flexibel und kann im flexiblen Zustand verwendet werden, aber auch mit einem festen oder flexiblen Substrat verbunden werden. Für einige Anwendungen ist es vorteilhaft, wenn die gesamte integrierte Schaltung flexible bleibt, z.B. um sie auf den gekrümmten Gehäusen von elektronischen Konsumgütern anzubringen oder auch nur, um Gewicht zu sparen. Ebenso kann eine großflächige flexible integrierte Schaltung für den Transport einfach gerollt werden.

Sie kann für die bereits beschriebenen Anwendungen sowie für eine Verwendung mit Hilfe konventioneller Etikettierungstechniken, Etikettierung von Lagerartikeln zur logistischen Erfassung des Lagerbestandes mit Hilfe kontaktloser Datenübertragung via Funk, Etikettierung von Ware, für großflächige integrierte Schalungen für Solarzellen und für Flachbildschirme mit TFT-Adressierung eingesetzt werden.

Ausführungsbeispiel Auf eine konventionell in Planartechnologie oder SOI-Technologie behandelte Siliziumscheibe mit integrierten monolithischen Schaltungen (Fig.1) wird am Prozeßende ein flüssiger Polymerenfilm (Fig. 2) von einigen Mikrometern Dicke auf die Bauteilseite aufgebracht und ausgehärtet. Das Aufbringen des Polymerenfilmes ist mit handelsüblichen Belackern innerhalb der Halbleiterfertigung durchführbar. Polyimid ist besonders gut geeignet, da es nach der Vernetzung mechanisch und thermisch sehr stabil ist.
Nach geeigneter Vorbehandlung mit einem Hartvermittler (Primer) wird auf die mit
Polyimid bedeckte Scheibe eine Trägerscheibe (Fig 3) durch einen Kleber, der sich später leicht ablösen läßt, fixiert (Fig.3, 4). Geeignet sind z.B. Acrylate oder Epoxy Kleber, die thermisch oder durch UV Bestrahlung aushärten. Die Trägerscheibe (z.B. Glas) sorgt während der nachfolgenden Entfernung des Siliziumsubstrats bis auf eine dünne verbleibende Schicht und deren weitere Behandlung für genügend Steifigkeit, um die Benutzung von halbleiterindustriespezifischen Maschinen zu ermöglichen. Die Trägerscheibe wird später wieder entfernt und kann weiterverwendet werden. Der Kleber hat für das Endprodukt ebenfalls keine Bedeutung

Das Silizium der bauteiltragenden Scheibe (Fig 4) wird nun von der Rückseite aus bis auf eine gewünschte Dicke (typisch 0.2 - 20 µm) durch mechanisches Schleifen und/oder nasschemisches Ätzen entfernt. Eine geeignete Ätzstoppschicht (Fig.4, 5), z.B. das vergrabene Oxid eines SOI-Wafers oder eine hochdotierte Schicht in der Siliziumscheibe, dient der Kontrolle des Silizium-Abtrages.

Es verbleibt eine dünne Schicht monokristallinen Siliziums inklusive Verdrahtungs-, Passivierungsschichten und einer Polyimidschicht verbunden mit der Trägerscheibe durch die Kleberschicht.

Diese auf der Trägerscheibe verbliebene Schicht inklusive aller Schaltungselemente wird auf der zurückgeätzten Oberfläche mit einer zusätzlichen Passivierung (z.B. Plasmanitrid oder BCB) beschichtet und mit Kontaktlöchern zur späteren Kontaktierung versehen. Es ist ebenfalls möglich, weitere Metallisierungslagen mit den in der Halbleiterindustrie üblichen Verfahren auf dieser Seite folgen zu lassen, so daß die späteren ICs auf der Ober- und Unterseite eine oder mehrere Verdrahtungsebenen aufweisen können.

Anschließend wird die Trägerscheibe entfernt (Fig. 6). Diese Trennung kann rein mechanisch ablaufen, indem die dünne Polyimidfolie (Kapton) mitsamt den integrierten Schaltungen von der Trägerscheibe abgezogen oder chemisch unterstützt abgelöst wird

Als Ergebnis verbleiben die integrierten monolithischen Schaltungen samt der Verdrahtung und Passivierung auf Ober- und Unterseite auf einer dünnen flexiblen und (wenn gewollt) transparenten Folie als Trägerschicht. Die Vorgehensweise ist nicht auf SOI-Scheiben beschränkt und kann mit allen herkömmlichen Halbleiterscheiben eines Halbleiterherstellungsprozesses durchgeführt werden.

Das beschriebene Verfahren wird nicht auf einzelne ICs angewendet, sondern es handelt sich um eine Ganzscheibenbearbeitung (wafer scale procesang), was gegenüber bisher bekannten Verfahren als deutlicher Unterschied und Vorteil zu sehen ist.

Das Vereinzeln der integrierten Schaltkreise kann direkt durch Ausstanzen aus der Folie oder nach einem weiteren Umklebeprozeß erfolgen.

## Patentansprüche

1. Flexible, monolithische integrierte Schaltung, die im wesentlichen aus flexiblen Schaltunggelementen, Vebindungselementen zwischen den flexiblen Schaltungselementen und einer flexiblen Beschichtung die mindestens eine Schicht aus einem Beschichtungsmaterial, das ein Polymer enthält, besteht.

2. Flexible, monolithische integrierte Schaltung gemäß Anspruch 1,
**dadurch gekennzeichnet,**
**dass** das Polymer ausgewählt ist aus der Gruppe der Polyimid-, Polycarbonat-, Fluorcarbon-, Polysulfon-, Epoxid-, Phenol-, Melamin, Polyester- und Siliconharze bzw. ihrer Copolymeren.

3. Flexible, monolithische integrierte Schaltung gemäß Anspruch 1,
**dadurch gekennzeichnet,**
**dass** das Polymer aus der Gruppe der Polyimidharze ausgewählt ist.

4. Flexible, monolithische integrierte Schaltung gemäß Anspruch 1,
**dadurch gekennzeichnet,**
**dass** das Beschichtungsmaterial ein Verstärkungsmaterial enthält.

5. Flexible, monolithische integrierte Schaltung gemäß Anspruch 1,
**dadurch gekennzeichnet,**
**dass** das Beschichtungsmaterial einen thermisch leitenden Füllstoff enthält.

6. Flexible, monolithische integrierte Schaltung gemäß Anspruch 1,
**dadurch gekennzeichnet,**
**dass** das Beschichtungsmaterial einen elektrisch leitenden Füllstoff enthält.

7. Flexible, monolithische integrierte Schaltung gemäß Anspruch 1,
**dadurch gekennzeichnet,**
**dass** das Beschichtungsmaterial ein Pigment enthält.

8. Flexible, monolithische integrierte Schaltung gemäß Anspruch 1,
**dadurch gekennzeichnet,**
**dass** die Beschichtung eine Feldplatte enthält.

9. Flexible integrierte monolithische Schaltung gemäß Anspruch 1,
**dadurch gekennzeichnet,**
**dass** die Beschichtung eine erste Schicht auf einer ersten Oberfläche und eine zweite Schicht auf einer zweiten Oberfläche der flexiblen integrierten monolithischen Schaltung umfaßt.

10. Verfahren zur Herstellung einer flexiblen integrierten monolithischen Schaltung,
bei dem integrierte monolithische Schaltungselemente und Verbindungselementen in und auf einem Halbleitersubstrat gebildet werden, die dem Halbleitersubstrat abgewandte erste Oberfläche der integrierten Schaltungselemente und der Vebindungselemente mit einer Beschichtung, die mindestens eine Schicht aus einem Beschichtungsmaterial, das ein Polymer enthält, versehen wird und das Halbleitersubstrat entfernt wird.

11. Verfahren zur Herstellung einer flexiblen integrierten monolithischen Schaltung gemäß
Anspruch 10
**dadurch gekennzeichnet,**
**dass** die Beschichtung durch ein Schleuderbeschichtungsverfahren aufgebracht wird.
